# EUROPEAN PATENT SPECIFICATION

(11) **EP 0 449 235 B1**
(45) Date of publication and mention of the grant of the patent: **05.11.1997**
(21) Application number: 91104814.8
(22) Date of filing: 26.03.1991
(51) Int. Cl.: G11C 11/407, G11C 5/14, G05F 3/20

(54) **Semiconductor memory comprising high efficiency charge pump circuit**
Halbleiterspeicher mit hochwirksamer Ladungspumpenschaltung
Mémoire à semiconducteurs avec circuit de pompe à charge à haute efficacité

(30) Priority: 26.03.1990 US 498772; 26.03.1990 US 498773
(43) Date of publication of application: 02.10.1991
(73) Proprietor: MICRON TECHNOLOGY, INC., Boise, ID 83706 (US)
(72) Inventor: Douglas, Kurt P., Boise, Idaho 83706 (US); Chern, Wen-Foo, Boise, Idaho 83706 (US)
(74) Representative: Klunker . Schmitt-Nilson . Hirsch

(56) References cited:
- EP-A- 0 032 588
- WO-A-80/00394
- US-A- 4 382 194

## Description

This invention relates to semiconductor circuit devices and more particularly to circuitry for providing current to sense amps on semiconductor integrated circuits. Still more precisely, the invention relates to a semiconductor memory comprising a charge pump circuit.

The invention uses various materials which are electrically either conductive, insulating or semiconducting, although the completed semiconductor circuit device itself is usually referred to as a "semiconductor". One of the materials used is silicon, which is used as either single crystal silicon or as polycrystalline silicon material, referred to as polysilicon or "poly" in this disclosure.

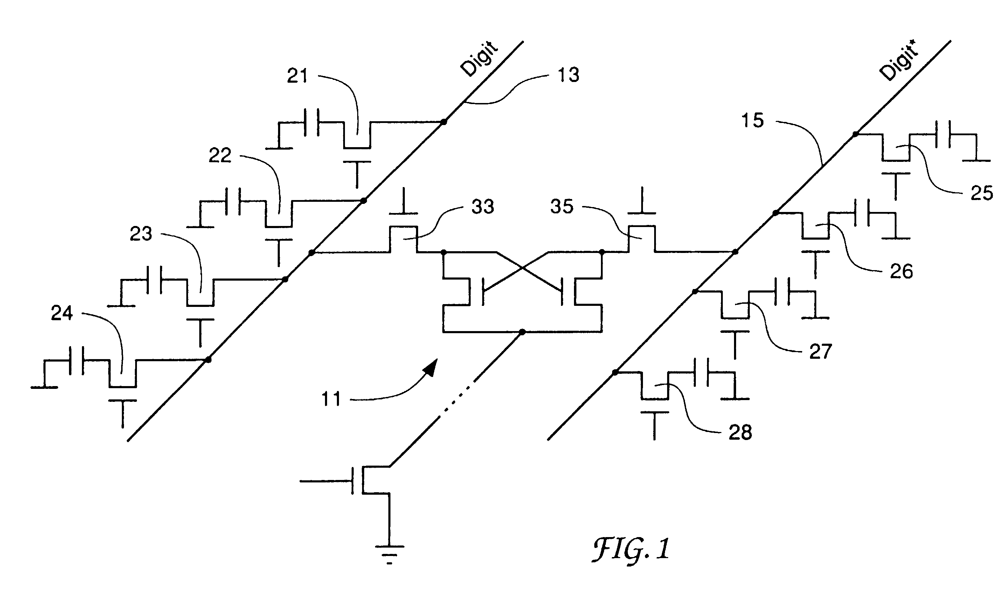

In the operation of certain semiconductor circuit devices, it is necessary to draw up a node of the sense amp to a potential above V_{CC}. In the conception of the present invention, these nodes occur on iso (isolation) devices on an array of a memory device and on word lines. Memory devices which use such iso devices on an array include DRAMs (dynamic random access memories). A typical arrangement of DRAM memory cells with a sense amp is shown in Figure 1. Other types of memory devices, such as static RAMs and video RAMs also may have similar circuit arrangements. An isolation device (iso device) is present in order to isolate a digit load from the sense amp, so that the sense amp can amplify the signal faster than if the digits were directly attached to the sense amp.

Gating an iso device with a higher potential speed read time reduces the required size of the iso device. These results are obtained because an increase in potential increases V_{GS}.

In a DRAM, the iso device is used with either multiplexed or non-multiplexed sense amps. In the case of multiplexed sense amps, reducing the size of the iso device allows configuring the circuit layout with the iso-devices "on pitch" (two pitch) rather than in a four pitch pattern. This simplifies layout design because the two pitch layout provides a configuration in which, for each sense amp, both iso devices are individually aligned with that sense amp. With four pitch layout patterns, more than one sense amp must be balanced as a unit.

The decrease in device width is obtained because increasing potential to gate gives the device a greater effective electrical transistor width.

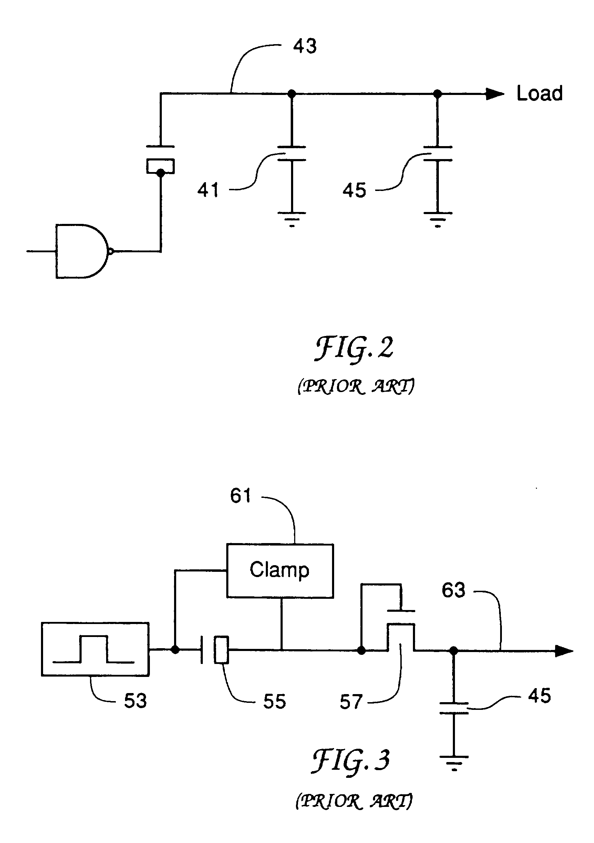

In the prior art, bootstrapping had been used in order to charge nodes of a circuit to an increased potential. A typical bootstrap circuit is shown in Figure 2. The bootstrap circuit provides an increased voltage level in response to a particular sequence, such as the receipt of a timing signal. Document WO-A1-80/00394 discloses an example of a boost circuit in which the gate of the output transistor is controlled by a boosted control voltage. The charge pump, on the other hand, provides a continuous output and an increased potential. The continuous high-potential output means that timing of the high-potential supply is not critical. This is particularly important when a high-potential node is used for the word line of a DRAM memory device, since the time required to select and address the word line is critical to the access speed of the DRAM.

Because the boot strap circuit is timed, individual boot strap circuits must be provided for each of several nodes, each of which receives current at the elevated potentials at different times. The charge pump, with its continuous output, can be used for supplying current to each of these nodes.

Boot strap circuits were also located at the location of the device controlled by the boot strap circuit. This was because individual boot strap circuits were dedicated to particular driven circuits in which different sequences were timed. Because the boot strap circuits were dedicated to particular driven circuits and because the boot strap circuits were timed to coincide with operation of the particular driven circuit, the amount of circuit area utilized by all of the circuitry was increased. This increase could occur despite the possibility of having smaller individual transistors in the driven circuits.

The ability to write a continuous voltage supply is particularly important in the case of word lines on DRAM devices. This is because, in DRAMs, word line addressing is particularly critical with respect to the speed of the part. Therefore, while providing a charge pump rather than a boot-strap circuit, the timing of the elevated potential output is not a condition precedent to word line access, simply because the charge pump output is not timed.

Prior art charge pumps consisted of an oscillator and capacitor. For example, EP-A2-0,032,588 discloses an example of a substrate bias generator circuit that utilizes an oscillator circuit. It does not require specific localized timing signals. In order to prevent latchup, a clamp circuit was used in order to control current from the oscillator to one side of the capacitor. The use of an oscillator and capacitor with a single clamp circuit provided a relatively constant elevated potential, but was somewhat inefficient when compared to a boot strap circuit. It would be desirable to provide a charge pump circuit which has the relative efficiencies of a boot strap circuit but yet provides a continuous output such as is associated with a charge pump.

Prior art charge pumps use an oscillator and capacitor, along with a clamp circuit. The oscillator provides current at a supply potential to one side of the capacitor and the clamp circuit is used to charge the other side. The current supplied to the capacitor by the oscillator generates an increased potential at an output node of the circuit. This prior art circuit is shown in Figure 3. From document US-A-4,382,194 a boosting circuit has come to be known. This known boosting circuit boosts a voltage of a load capacitor which is charged by a specific voltage.

It is desirable to design an auxiliary circuit, so that in the event that the auxiliary circuit does not function as anticipated, the auxiliary circuit can be bypassed. Specifically, during the design of an integrated circuit such as a DRAM, it is not known whether the electrical characteristics of the charge pump will exceed the limits of the circuit which receives the current from the charge pump. If the limits are exceeded, it is desirable to be able to make a small modification in the masks and thereby bypass the charge pump without sacrificing the remainder of the circuit design.

It is also likely that different product applications for integrated circuit parts may have different requirements of speed and supply voltage. If the auxiliary circuit provides a desireable function for one product application, but would make the part unsuitable for another product application, it would be desireable to be able to selectively bypass the auxiliary circuit. This would enable a single integrated circuit layout design to be used for both parts.

Ideally, an auxiliary circuit should automatically respond to circuit conditions which make the auxiliary circuit unsuitable for its application. For example, a voltage boosting circuit would ideally attenuate its increased potential output or bypass itself as external system voltage becomes sufficiently high to make the use of the boosting circuit undesirable.

The technical problem is solved according to the invention by a semiconductor memory comprising a charge pump circuit exhibiting the features as set out with Claim 1. Dependent Claims 2 to 6 exhibit further improvements of the subject-matter of Claim 1.

An integrated circuit device includes a charge pump to provide current at a potential which is greater than a supply potential. The current is supplied to certain nodes on the integrated circuit device in order to enhance the performance of the integrated circuit device.

Used with an integrated circuit device, such as a DRAM, the current from the charge pump is supplied to nodes on isolation devices and nodes on word lines. This allows the nodes to be operated at an elevated potential, thereby improving the performance of the DRAM. This enhanced performance is achieved without substantially changing the circuit configuration of the DRAM array, so that, in the event that the use of the charge pump proves to be inopportune, the charge pump can be bypassed by minor changes in the masks used to produce the integrated circuit device. This configuration allows the same basic mask layout to be used in different DRAMs designed to operate under different parameters.

The charge pump is designed to operate at a higher efficiency by the use of a pair of clamp circuits. An oscillator provides an output to a pair of capacitors. Each capacitor is bypassed respectively by one of the clamp circuits, and the clamp circuits are separately timed. The output of the first capacitor is also connected to an output transistor which is gated by the second clamp circuit connected in parallel to the second capacitor. The controlled gating of the output transistor permits the clamp circuit to maintain a continuous output at an elevated potential, while reducing power loss caused by impedances within the charge pump circuit.

A threshold maintenance circuit is provided which conducts currents to the nodes supplied by the charge pump when the potential at these nodes is below a predetermined potential level. This preferably includes a potential maintenance transistor connected between the charge pump's output and having a source and drain connection in a series connection between the signal level voltage source and the output node.

The threshold maintenance circuit makes it possible to alter the inventive integrated circuit to function without its charge pump by fuse repair techniques. Fuse repair techniques permit a circuit on a device to be deliberately "damaged" by either direct application of energy, such as laser cutting, or by application of an excess amount of electrical energy through connection points (pinout connections) on an integrated circuit. This removes the functionality of a part of the circuit, and bypasses that circuit. In the case of a charge pump, the fuse repair would either permit the charge pump circuitry to directly conduct supply current to the output node of the charge pump, or would permit a separate circuit to conduct to the output node in lieu of the charge pump.

A potential limiting circuit responds to potential at the charge pump's output to attenuating the output when the potential at the output node exceeds a predetermined level. In the preferred embodiment, the potential limiting circuit is responsive to a predetermined potential threshold above that of the signal level voltage source to limit the output of the oscillator.

It is further possible to alter the integrated circuit to function without its charge pump by fuse repair techniques. Fuse repair techniques permit a circuit on a device to be deliberately "damaged" by either direct application of energy, such as laser cutting, or by application of an excess amount of electrical energy through connection points (pinout connections) on an integrated circuit. This removes the functionality of a part of the circuit, and bypasses that circuit. In the case of a charge pump, the fuse repair would either permit the charge pump circuitry to directly conduct supply current to the output node of the charge pump, or would permit a separate circuit to conduct to the output node in lieu of the charge pump.

Likewise, it is possible to provide the charge pump with an overvoltage shutoff circuit. The overvoltage shutoff circuit would permit the charge pump to operate under conditions of low supply voltage, but allows the charge pump to be effectively bypassed when supply voltage is sufficiently high to make bypass desireable.

By using the charge pump as a source of elevated potential, the circuit layout of the DRAM array is simplified and the potential boosting circuitry can be located outside of the array, on the periphery of the integrated circuit.

The invention will now be explained by way of example referring to the drawing:
Figure 1 shows a configuration of sense amps in a DRAM array;
Figure 2 (prior art) shows an equivalent circuit of the output of a bootstrap circuit;
Figure 3 (prior art) schematically shows a prior art configuration of a charge pump;
Figure 4 is a schematic block diagram of a charge pump constructed in accordance with the present invention; and
Figure 5 schematically shows the charge pump of Figure 4.

Referring to Fig. 1, a sense amp 11 is connected between digit and digit* lines 13, 15 on a memory array. The digit and digit* lines 13, 15 are connected to an array of memory cells, such as cells 21-28 shown.

The memory cells 21-28 are connected to the digit and digit* lines through word lines, such as word line 31. Iso devices 33, 35 are used to gate the current between the sense amp 11 and either of the digit and digit* lines 13, 15 in order to permit the differential amp 11 to sense the relative levels of the digit and digit* lines 13, 15. By selectively gating one of the memory cells 21-28 to either the digit or the digit* lines, it is possible to detect the memory storage level in the memory cell. The memory storage level is either higher or lower than that of the unconnected digit and digit* lines, according to whether the bit represented by that level is a logical low (zero) or high (one). Hence, the sense amp 11 is a differential amplifier which senses the difference between one of the digit and digit* lines connected to a selected memory cell and the other one of the digit and digit* lines, which is not connected to a cell.

In order to increase the sensitivity of the differential amp 11 and to permit the differential amp 11 to more rapidly respond to the differential potential in the digit and digit* lines 13, 15 the iso devices 33, 35 must have a relatively large effective transistor width. One way to accomplish this without increasing the physical size of the iso devices 33, 35 is to gate the iso devices 33, 35 at a slightly elevated potential. In other words, it is advantageous to have V_{GS} greater than V_{CC}. Having V_{GS} greater than V_{CC} reduces resistance between gate and source, thereby increasing effective transistor width.

This is a trade off because smaller iso devices make sensing faster but slows down the time to fully discharge the DIGIT and DIGIT* lines to ground. Bigger iso devices allow DIGIT or DIGIT* to be written to opposite states faster. For a given desired drive ability, the iso device can be smaller if V_{GS} is elevated. Furthermore, a smaller iso device is easier to design into high density circuitry.

If a bootstrap circuit is used to provide an elevated voltage, the equivalent circuit appears as shown in Figure 2. The bootstrap circuit includes a boost capacitor 41 which provides current at an elevated potential at node 43. The node 43 has a strong capacitance, indicated at 45. This strong capacitance 45 may be unpredictable until the circuit is constructed, but is believed to stabilize the potential from the charge pump and, in effect, function as an integral part of the charge pump circuit.

Fig. 3 shows a prior art charge pump 51. As can be seen, the charge pump consists of an oscillator 53, which provides its output to a capacitor 55 and to a diode 57. The output of the oscillator is also connected to a clamp circuit 61, which functions to provide current to an output node 63.

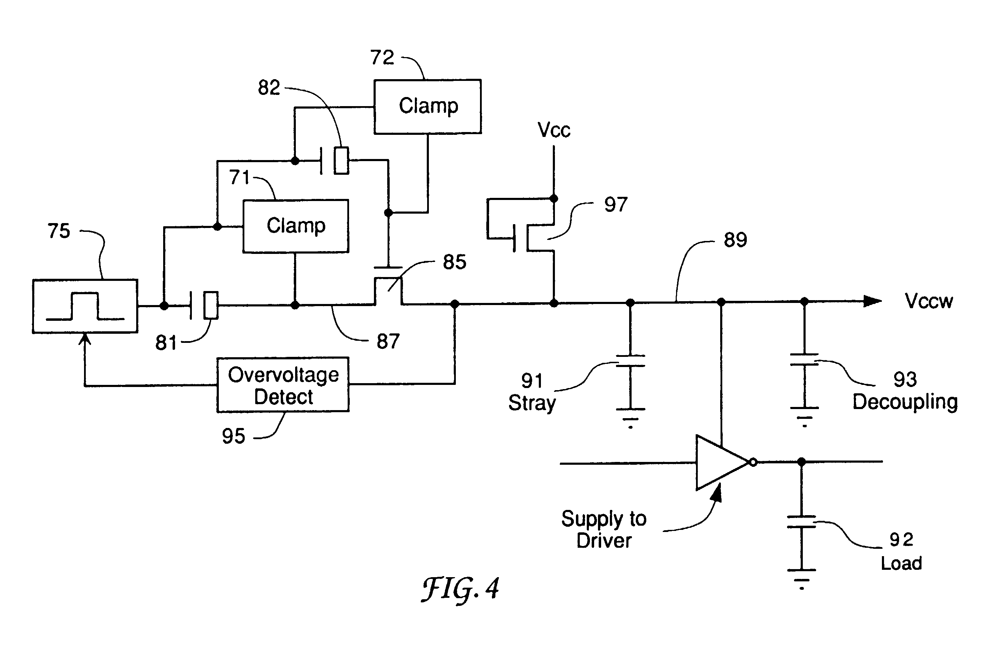

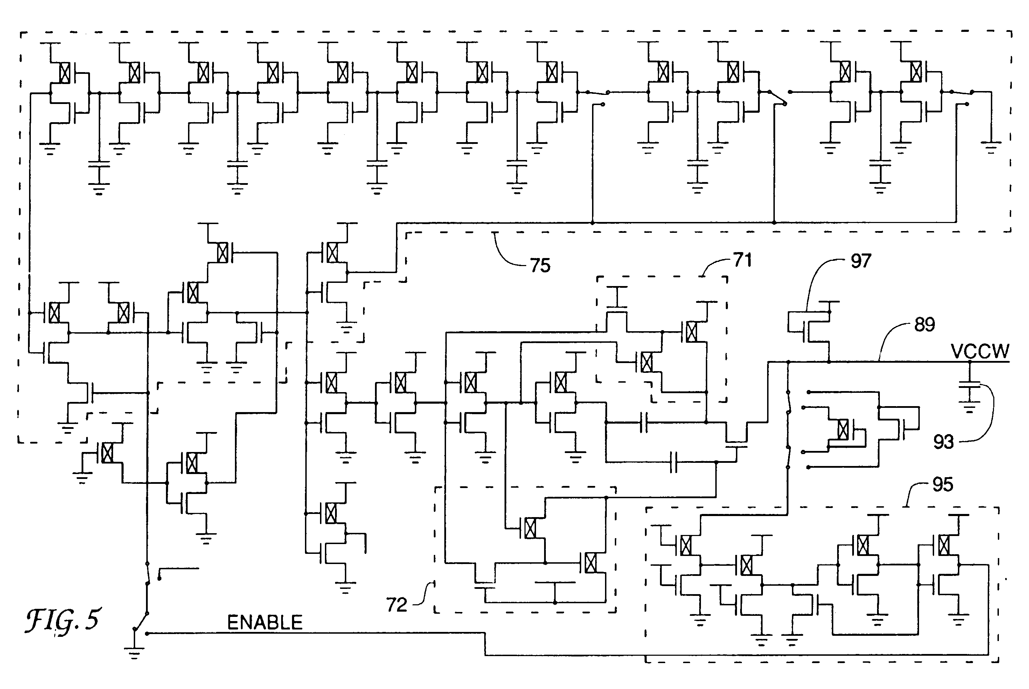

The circuit, shown at Figs. 4 and 5, uses two clamp circuits 71, 72. This increases the efficiency of the charge pump and thereby provides a higher potential with less power consumption. An oscillator 75 provides its output to first and second capacitors 81, 82. The clamp circuits 71, 72 are connected across the capacitors 81, 82.

The oscillator 75 is a ring oscillator which can be metal mask adjusted to increase or decrease frequency.

Instead of diode 57 (Fig. 3), an output transistor 85 is connected between node 87 of capacitors 81 and a circuit output 89 node. The circuit output is an elevated potential current source, and is identified as V_{CCW}. The combination of clamp circuit 72 and capacitor 82 is used to control the output of the charge pump.

Both clamp circuits 71, 72 turn on and off at the same time, but the connection of clamp circuit 72 across capacitor 82 and in series with the output transistor has the result that the operation of the second clamp circuit 72 causes the output transistor 85 to conduct when potential at the node 87 is at a high potential. The rising edge of the oscillator 75 couples a high voltage through the capacitors 81, 82 which shuts the clamps 71, 72 off and allows the nodes 87, 89 to go high. The falling edge of the output of the oscillator 75 couples a drop in potential through the capacitors 81, 82, at which point, the clamps 71, 72 turn on, preventing the nodes 87, 89 from going low.

The line capacitance at the output and the capacitance of the load, represented as 91, 92 cooperate with the switched output of capacitor 81 in order to provide a boosted potential output to the load (at 92). A decoupling capacitor 93 further cooperates with the charge pump in order to provide a steady boosted output.

An overvoltage shutoff circuit 95 is provided in order to prevent the potential at the load from exceeding a predetermined value. The overvoltage shutoff circuit 95 senses a high voltage on the output node 89. When that level goes above a certain threshold, the shutoff circuit causes the oscillator 75 to stop oscillating. After enough charge has leaked off, the pumped potential at node 89 will eventually drop after supplying the row lines and/or iso devices with charge. The overvoltage shutoff circuit 95 will then turn on the oscillator 75 and allow the oscillator 75 to run again.

In the preferred embodiment, the overvoltage shutoff circuit 95 provides an ENABLE output to the oscillator 75. The connection of the overvoltage shutoff circuit 95 to the oscillator 75 is configured as a NAND gate, thereby disabling the oscillator when the ENABLE output goes low.

On the other hand, if the potential provided by the charge pump is inadequate, a diode connected transistor 97 is used to effectively bypass the charge pump. This transistor 97 is an n channel device connected to a supply voltage node V_{CC}. The transistor 97 will conduct from V_{CC} to node 89 as long as V_{CCW} < (V_{CC} - V_{T}). It is off whenever V_{CCW} > (V_{CC} - V_{T}). This portion of the circuit also helps charge up V_{CCW} on power up.

## Claims

1. A semiconductor memory comprising a charge pump circuit for providing an elevated potential above a signal level voltage (Vcc) of a signal level voltage source to an output node of charge pump circuit for elevating the potential present at selected device nodes associated with word lines of the semiconductor memory for carrying storeable signals, comprising:
a) an oscillator (75) for providing an oscillating output determined by the signal level voltage source (Vcc);
b) a first capacitor (81) connected between the oscillator output and a first node (87) and capable of storing a first node potential at the first node in response to the oscillating output;
c) a first clamp circuit (71) connected in parallel with the first capacitor and responsive to the oscillating output for controlling the first node potential in accordance with the oscillating output;
d) a first switching circuit (85) connected in series with the first capacitor between the first capacitor at the first node and an output node,
e) a first switch control circuit (72, 82) being responsive to the oscillating output for controlling the first switching circuit to be opened and closed in response to a low and high oscillating output, respectively, to place the output node at an output node potential increased to the elevated potential; and
f) a decoupling capacitor (93) being connected between the output node and a ground potential for storing charge to maintain the output node potential.

2. The semiconductor memory comprising a charge pump circuit of claim 1, **characterized in that** the first switching circuit comprises a transistor device (85) having its source connected to the first capacitor at the first node; its drain connected to the output node; and its gate connected to the first switch control circuit, the first switch control circuit controlling the first switching circuit by controlling the gate of the first switching circuit.

3. The semiconductor memory comprising a charge pump circuit of claim 2, **characterized in that** the first switch control circuit comprises:
a) a second capacitor (82) connected in series between the oscillator output and the gate of the transistor device (85), the second capacitor being capable of storing a second capacitor potential in response to the oscillating output; and
b) a second clamp circuit (72) connected between the oscillator output and the gate of the transistor device (85) in parallel with the second capacitor, the second clamp circuit being responsive to the oscillating output for controlling the gate to be responsive to the second capacitor potential to cause the first switching circuit to place the output node potential at the elevated potential.

4. The semiconductor memory comprising a charge pump circuit of claim 1, characterized in that the charge pump circuit further comprises a minimum voltage maintenance circuit (97) electrically connected to the output node and the signal level voltage for maintaining the output node potential at a first predeterminated voltage.

5. The semiconductor memory comprising a charge pump circuit of claim 4, characterized in that the minimum voltage maintenance circuit comprises:
a) a transistor (97) having its gate and its source connected to the signal level voltage source and its drain connected to the output node;
b) the transistor (97) maintaining the output node at the first predetermined voltage substantially close to the signal level voltage when the output node potential falls below the signal level voltage by a second predetermined voltage.

6. The semiconductor memory comprising a charge pump circuit of claim 1 or 4, **characterized in that** the charge pump circuit further includes a maximum voltage protection circuit comprising:
a) a circuit (95) for generating an enable signal when the output node potential is below a third predetermined voltage and for discontinuing the generation of the enable signal when the output node potential is above the third predetermined voltage;
b) the oscillator being responsive to the enable signal such that the oscillator is disabled in the absence of the enable signal.

## Patentansprüche

1. Halbleiterspeicher mit einer Ladungspumpschaltung zur Bereitstellung eines erhöhten Potentials oberhalb einer Signalpegelspannung (Vcc) einer Signalpegelspannungsquelle an einem Ausgangsknoten der Ladungspumpschaltung zum Erhöhen des Potentials an ausgewählten Bauelementknoten, die Wortleitungen des Halbleiterspeichers zugeordnet sind, um speicherbare Signale zu führen, umfassend:
a) einen Oszillator (75) zur Bereitstellung eines Schwingungsausgangssignals, welches von der Signalpegelspannungsquelle (Vcc) bestimmt wird;
b) einen ersten Kondensator (81), der zwischen den Oszillatorausgang und einem ersten Knoten ( 87) gekoppelt und in der Lage ist, ein erstes Knotenpotential an dem ersten Knoten in Abhängigkeit des Schwingungsausgangssignals zu speichern;
c) eine erste Klemmschaltung (71), die parallel zu dem ersten Kondensator geschaltet ist und auf das Schwingungsausgangssignal anspricht, indem sie das erste Knotenpotential nach Maßgabe des Schwingungsausgangssignals steuert;
d) eine erste Schalteinrichtung (85), die in Reihe zu dem ersten Kondensator zwischen dem ersten Kondensator an dem ersten Knoten und einem Ausgangsknoten geschaltet ist;
e) eine erste Schaltsteuerschaltung (72, 82), die auf das Schwingungsausgangssignal anspricht, um die erste Schalteinrichtung abhängig von einem niedrigen und einem hohen Schwingungsausgangssignal zum Öffnen bzw. zum Schliessen zu veranlassen, um den Ausgangsknoten auf ein Ausgangsknotenpotential zu bringen, welches auf das erhöhte Potential angehoben ist; und
f) einen Entkopplungskondensator (93), der zwischen dem Ausgangsknoten und Massepotential liegt, um Ladung zu speichern und das Ausgangsknotenpotential zu halten.

2. Halbleiterspeicher mit einer Ladungspumpschaltung nach Anspruch 1,
**dadurch gekennzeichnet,**
daß die erste Schalteinrichtung ein Transistorbauelement (85) aufweist, dessen Source mit dem ersten Kondensator an dem ersten Knoten verbunden ist, dessen Drain mit dem Ausgangsknoten verbunden ist, und dessen Gate an die erste Schaltsteuerschaltung angeschlossen ist, wobei die erste Schaltsteuerschaltung die erste Schalteinrichtung dadurch steuert, daß sie das Gate der ersten Schalteinrichtung steuert.

3. Halbleiterspeicher mit Ladungspumpschaltung nach Anspruch 1,
**dadurch gekennzeichnet,**
daß die erste Schaltsteuerschaltung aufweist:
a) einen zweiten Kondensator (82), der in Reihe zwischen dem Oszillatorausgang und dem Gate des Transistorbauelements (85) liegt, wobei der zweite Kondensator in der Lage ist, ein zweites Kondensatorpotential in Abhängigkeit des Oszillatorausgangssignals zu speichern; und
b) eine zweite Klemmschaltung (72), die zwischen dem Oszillatorausgang und dem Gate des Transistorbauelements (85) parallel zu dem zweiten Kondensator liegt, wobei die zweite Klemmschaltung auf das Oszillatorausgangssignal anspricht, indem sie das Gate so steuert, daß es auf das zweite Kondensatorpotential anspricht, um die erste Schalteinrichtung zu veranlassen, das Ausgangsknotenpotential auf das erhöhte Potential zu bringen.

4. Halbleiterspeicher mit einer Ladungspumpschaltung nach Anspruch 1,
**dadurch gekennzeichnet,**
daß die Ladungspumpschaltung außerdem eine Minimumspannungs-Halteschaltung (97) aufweist, die elektrisch an den Ausgangsknoten und die Signalpegelspannung gekoppelt ist, um das Ausgangsknotenpotential auf einer ersten vorbestimmten Spannung zu erhalten.

5. Halbleiterspeicher mit Ladungspumpschaltung nach Anspruch 4,
**dadurch gekennzeichnet,**
daß die Minimumspannungs-Halteschaltung aufweist:
a) einen Transistor (97), dessen Gate und Source an die Signalpegelspannungsquelle angeschlossen sind, und dessen Drain an den Ausgangsknoten gekoppelt ist;
b) wobei der Transistor (97) den Ausgangsknoten auf der ersten vorbestimmten Spannung etwa in der Nähe der Signalpegelspannung hält, wenn das Ausgangsknotenpotential um eine zweite vorbestimmte Spannung unter die Signalpegelspannung abfällt.

6. Halbleiterspeicher mit Ladungspumpschaltung nach Anspruch 1 oder 4,
**dadurch gekennzeichnet,**
daß die Ladungspumpschaltung außerdem eine Maximalspannungs-Schutzschaltung aufweist, welche umfaßt:
a) einen Schaltkreis (95) zum Erzeugen eines Freigabesignals, wenn das Ausgangsknotenpotential unter einer dritten vorbestimmten Spannung liegt, und zum Beendigen der Erzeugung des Freigabesignals, wenn das Ausgangsknotenpotential oberhalb der dritten vorbestimmten Spannung liegt;
b) wobei der Oszillator auf das Freigabesignal in der Weise anspricht, daß er bei Fehlen des Freigabesignals außer Betrieb gesetzt wird.

## Revendications

1. Mémoire à semi-conducteur comprenant un circuit de pompage de chargement, servant à fournir un potentiel haut, supérieur à un niveau de tension de signaux (Vcc), d'une source de tension de niveau de signaux, à un noeud de sortie d'un circuit de pompage de chargement, afin d'augmenter le potentiel présent au niveau des noeuds sélectionnés de dispositifs associés à des lignes de mots de la mémoire à semi-conducteur, afin de véhiculer des signaux stockables, comprenant :
(a) un oscillateur (75) fournissant un signal de sortie oscillant déterminé par la source de tension de niveau de signaux (Vcc);
(b) un premier condensateur (81) connecté entre la sortie de l'oscillateur et un premier noeud (87) et pouvant stocker un premier potentiel de noeud au niveau du premier noeud, en réponse au signal de sortie oscillant;
(c) un premier circuit de blocage (71) connecté en parallèle au premier condensateur et répondant au signal de sortie oscillant, afin de contrôler le premier potentiel de noeud d'après le signal de sortie oscillant;
(d) un premier circuit de commutation (85) connecté en série au premier condensateur entre le premier condensateur et le premier noeud et un noeud de sortie,
(e) un premier circuit de commande de commutation (72, 82) répondant au signal de sortie oscillant servant à commander le premier circuit de commutation, devant être ouvert et fermé d'après un signal de sortie oscillant de niveau bas et haut, respectivement, en vue de placer le noeud de sortie d'un potentiel de noeud de sortie à une valeur plus haute que le potentiel haut; et
(f) un condensateur de découplage (93) étant connecté entre le noeud de sortie et un potentiel de masse, afin de stocker une charge permettant de maintenir le potentiel de noeud de sortie.

2. Mémoire à semi-conducteur comprenant un circuit de pompage de chargement selon la revendication 1, caractérisée en ce que le premier circuit de commutation comprend un dispositif à transistor (85) dont la source est connectée au premier condensateur au niveau du premier noeud, son drain est connecté au noeud de sortie, et sa grille est connectée au premier circuit de commande de commutation, le premier circuit de commande de commutation commandant le premier circuit de commutation par une commande de la grille du premier circuit de commutation.

3. Mémoire à semi-conducteur comprenant un circuit de pompage de chargement selon la revendication 2, caractérisée en ce que le premier circuit de commande de commutation comprend :
(a) un deuxième condensateur (82) connecté en série entre la sortie d'oscillateur et la grille du dispositif à transistor (85), le deuxième condensateur pouvant stocker un deuxième potentiel de condensateur en réponse au signal de sortie oscillant;
(b) un deuxième circuit de blocage (72) connecté entre la sortie d'oscillateur et la grille du dispositif à transistor (85), en parallèle au deuxième condensateur, le deuxième circuit de blocage répondant au signal de sortie oscillant afin de commander la grille pour répondre au deuxième potentiel de condensateur, de façon à forcer le premier circuit de commutation à placer le potentiel de noeud de sortie au niveau du potentiel haut.

4. Mémoire à semi-conducteur comprenant un circuit de pompage de chargement selon la revendication 1, caractérisée en ce que la circuit de pompage de chargement comprend en outre un circuit de maintien de tension minimale (97) connecté électriquement au noeud de sortie et au niveau de tension de signaux, afin de maintenir le potentiel de noeud de sortie à une première tension prédéterminée.

5. Mémoire à semi-conducteur comprenant un circuit de pompage de chargement selon la revendication 4, caractérisé en ce que le circuit de maintien de tension minimale comprend :
(a) un transistor (97) dont la grille et la source sont connectés à la source de tension de niveau de signaux et dont le drain est connecté au noeud de sortie;
(b) le transistor (97) maintenant le noeud de sortie au niveau de la première tension prédéterminée, sensiblement près de la tension de niveau de signaux, lorsque le potentiel de noeud de sortie chute au-dessous de la tension de niveau de signaux selon une deuxième tension prédéterminée.

6. Mémoire à semi-conducteur comprenant un circuit de pompage de chargement selon la revendication 1 ou 4, caractérisée en ce que le circuit de pompage de chargement comprend en outre un circuit de protection contre une tension maximale, comprenant :
(a) un circuit (95) produisant un signal de validation, lorsque le potentiel de noeud de sortie est inférieur à une troisième tension prédéterminée et servant à interrompre la production du signal de validation, lorsque le potentiel de noeud de sortie est supérieur à la troisième tension prédéterminée;
(b) l'oscillateur répondant au signal de validation, de manière que l'oscillateur soit mis hors service en l'absence du signal de validation.
